(19) Europäisches Patentamt
European Patent Office
Office européen des brevets

(11) **EP 1 692 534 B1**

(12) # FASCICULE DE BREVET EUROPEEN

(45) Date de publication et mention de la délivrance du brevet:
**15.05.2013 Bulletin 2013/20**

(21) Numéro de dépôt: **04816192.1**

(22) Date de dépôt: **02.09.2004**

(51) Int Cl.:
***G01R 33/385*** *(2006.01)*

(86) Numéro de dépôt international:
**PCT/FR2004/050411**

(87) Numéro de publication internationale:
**WO 2005/029110 (31.03.2005 Gazette 2005/13)**

(54) **SYSTEME D’ENROULEMENT DE GRADIENT MAGNETIQUE COMPRENANT DES BOBINES SOLENOIDALES CIRCULAIRES**

MAGNETGRADIENTEN-WICKLUNGSSYSTEM MIT ZIRKULÄREN SOLENOIDSPULEN

MAGNETIC GRADIENT WINDING SYSTEM COMPRISING CIRCULAR SOLENOID COILS

(84) Etats contractants désignés:
**DE FR GB NL**

(30) Priorité: **15.09.2003 FR 0350541**

(43) Date de publication de la demande:
**23.08.2006 Bulletin 2006/34**

(73) Titulaire: **Commissariat à l’Énergie Atomique et aux Énergies Alternatives
75015 Paris (FR)**

(72) Inventeur: **AUBERT, Guy
F-86000 POIRIERS (FR)**

(74) Mandataire: **Thévenet, Jean-Bruno et al
Cabinet Beau de Loménie
158, rue de l’Université
75340 Paris Cédex 07 (FR)**

(56) Documents cités:
**US-A- 4 985 679 US-A- 5 530 355**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

**Description**

La présente invention a pour objet une machine de résonance magnétique nucléaire (RMN), utilisable notamment, mais pas seulement, dans le domaine médical. Le but de l'invention est de concourir à la création d'images, et donc de permettre la différenciation des excitations des différentes parties d'un volume sous examen par adjonction de codages magnétiques de l'espace, temporaires ou permanents. Ces codages sont appliqués par des bobines de gradient. Le but de l'invention est de perfectionner les bobines de gradient du fait de l'évolution des conditions d'utilisation des machines de RMN, notamment l'augmentation du champ principal, l'augmentation concomitante de l'intensité des gradients et la réduction du bruit acoustique qu'ils produisent.

Dans le domaine de la résonance magnétique nucléaire, on connaît des machines de plusieurs types. Des machines à aimants permanents, souvent n'adoptant pas une structure tunnel, sont destinées à des champs orientateurs de l'ordre de 0,15 tesla. Des machines tunnels, de type résistif ou de type supraconducteur sont plus particulièrement intéressantes pour l'invention. Dans la pratique, l'invention est plutôt destiné aux machines de type supraconducteur pour lesquelles le champ orientateur actuel est de l'ordre de 1,5 à 3 teslas en utilisation clinique courante, de l'ordre de 4 à 4,5 teslas dans les expérimentations médicales, de plus de 9 teslas pour des machines à la pointe de la technique (à Chicago, Etats-Unis d'Amérique, par exemple) et jusqu'à 11,74 teslas dans les projets les plus récents. Des rappels concernant l'imagerie par résonance magnétique nucléaire sont disponibles dans le document de brevet européen EP-A-0 221 810. Dans ce document de brevet, on indique par ailleurs comment calculer des bobines de gradient qui soient les plus linéaires possibles compte tenu d'un encombrement donné. Dans le document de brevet PCT publié sous le numéro WO-A-89/03031, on montre par ailleurs comment, pour des bobines de gradient notamment celles présentées dans le précédent document de brevet, on peut s'affranchir de problèmes de courants de Foucault.

Comme indiqué dans ces deux documents, le caractère temporaire des impulsions de gradient nécessite de résoudre, en plus d'un problème de linéarité du champ que ces bobines de gradient procurent (on parle à ce propos communément d'homogénéité, terme qui sera utilisé dans la suite du texte), des problèmes liés au caractère pulsé. Autant l'augmentation de l'intensité du champ orientateur d'une machine de RMN conduit d'une part à acquérir des images de meilleure qualité, autant elle élève en fréquence le signal de RMN détectable. Pour les machines à plus fort champ indiquées ci-dessus, cette fréquence atteindra 500 MHz. Le maintien d'utilisation de bobines de gradient conçues pour des machines à plus bas champ conduit à une perte de sensibilité relative de la composante utile de gradient de champ (celle qui est orientée parallèlement au champ orientateur de la machine). En effet, une pente de gradient de l'ordre de 10 milliteslas par mètre est suffisante pour des machines fonctionnant à 1 tesla. Par contre, pour des machines fonctionnant à environ 10 teslas, une pente de 100 à 150 milliteslas par mètre est recherchée. Il convient donc de réaliser des bobines de gradient (on dit en raccourci des gradients) susceptibles de produire une variation plus importante de la composante de différenciation de l'espace.

De tels gradients plus puissants conduisent à plusieurs types de problèmes. Premièrement, la puissance dissipée par les bobines de gradient capables de telles pentes devient très importante : de l'ordre de quelques dizaines de kW. Il convient donc de mettre en place un refroidissement efficace pour que ces gradients ne viennent pas réchauffer le patient et le cryostat dans lequel est contenue la bobine supraconductrice d'aimantation principale.

En outre, dans des séquences d'imagerie utilisées actuellement, des séquences rapides comportent l'application d'impulsions de gradient dont la durée est de l'ordre de quelques millisecondes et dont les temps de montée et de descente doivent être de l'ordre de la milliseconde.

Avec les puissances électriques mises en jeu, les bobines de gradient se retrouvent alors soumises, dans le champ orientateur de la machine, à des accélérations très violentes dues aux forces électromagnétiques. Ces accélérations provoquent d'une part à court terme la détérioration de la machine et d'autre part la production de bruits insupportables par le patient sous examen. La contrainte de bruit est par ailleurs une contrainte particulièrement néfaste lorsque, notamment dans le cadre de l'examen du cerveau, on cherche à mettre en évidence les zones du cerveau qui sont sollicitées lors d'un exercice intellectuel particulier. Il est alors difficile de demander à un patient de se livrer à un exercice intellectuel particulier (par exemple effectuer des opérations d'addition ou de multiplication mentalement) tout en le soumettant à un bruit trépidant qui gène sa concentration.

Quand bien même ce type d'expérience serait envisageable avec un être humain, les expériences pré-cliniques effectuées avec des animaux ne sont alors pas possibles si ces animaux sont sollicités par ailleurs par ces bruits.

L'ensemble de ces problèmes doit bien entendu être résolu en tenant compte du fait que l'encombrement des bobines de gradient est limité, pour laisser un volume d'examen utile suffisamment grand. A titre indicatif, on retiendra parce que c'est maintenant une habitude dans le domaine, que le volume utile d'examen est un tunnel de section circulaire dont le diamètre doit avoir une valeur d'environ 550 millimètres, les bobines de gradient devant tenir dans un espace annulaire compris entre ce volume tunnel utile et le volume à l'intérieur des enveloppes du cryostat. Ce volume intérieur au cryostat dégage un tunnel circulaire d'environ 1000 millimètres de diamètre.

Par ailleurs le caractère pulsé des impulsions de gradient provoque des phénomènes parasites d'apparition de courants de Foucault qui, d'une part, échauffent la machine et, d'autre part, détruisent la linéarité du gradient pendant leur existence. Il est connu notamment par les documents cités ci-dessus de concevoir des bobines de compensation elles aussi à loger dans l'espace annulaire disponible pour éviter ce problème.

Il est connu par la thèse : "Quiet magnetic resonance imaging gradients" due à An Da Yeo en octobre 2000, Université de Queensland en Australie, page 31 et suivantes, la possibilité de réaliser des bobines de gradient dans lesquelles le retour de courant s'effectue sur une circonférence d'un cercle de plus grand diamètre que celui où circule le courant utile à la création du gradient. La solution présentée comporte cependant l'inconvénient qu'on ne peut réaliser que deux secteurs angulaires ne dépassant pas $\pi/2$ pour accueillir les gradients d'orientation. En effet, comme il convient de mettre à la fois des bobines de gradient X et des bobines de gradient Y, la présence de ces bobines sur un même mandrin général conduit à restreindre l'espace disponible pour chacun de ces deux jeux de bobines à deux secteurs cylindriques d'ouverture $\pi/2$ à chaque fois. Cette limitation de l'ouverture interdit, en pratique, d'obtenir la linéarité souhaitée pour les gradients.

Dans l'invention on a voulu résoudre l'ensemble de ces problèmes et notamment un problème de fabrication parce que la solution présentée par la thèse ci-dessus n'était pas exploitable industriellement. Dans l'invention, pour réaliser les gradients, on a prévu de consacrer l'espace annulaire disponible à la mise en place de tubes dans lesquels sont engagées des bobines solénoïdales circulaires. De préférence les tubes sont contigus les uns aux autres et forment une nappe de tubes. Il serait toutefois envisageable, au moins théoriquement, d'y disposer plusieurs nappes de tubes de plus petit diamètre. Chaque nappe serait concentriquement disposée dans cet espace annulaire.

On montrera par la suite comment la disposition des bobines dans les tubes permet d'aboutir au résultat escompté de grande intensité des gradients produits grâce à des possibilités de refroidissement améliorées, de respect des contraintes de linéarité imposées par les spécifications, de réduction des bruits acoustiques et de limitation des courants de Foucault.

La disparition des bruits provient de la structure solénoïdale des bobines engagées dans des tubes d'axes parallèles au champ principal et de leurs sollicitations uniquement radiales à leur propre structure, le torseur résultant des contraintes électromagnétiques étant nul.

On montrera par ailleurs que les structures ainsi préconisées, notamment pour les gradients X et Y, ayant une orientation de champ perpendiculaire aux bobines de gradient classiques produisent dans les écrans ou les différentes enveloppes métalliques du cryostat des courants de Foucault notablement plus faibles, qu'il n'est même plus nécessaire de compenser.

Un des principes de l'invention est donc de réaliser des bobines circulaires au lieu de réaliser des bobines trapézoïdales comme celles suggérées par la thèse mentionnée ci-dessus. Une autre idée principale de l'invention est de réduire l'ouverture du secteur cylindrique circulaire. Au lieu d'utiliser $\pi/2$, on utilise une fraction inférieure d'un secteur cylindrique, de manière à placer d'autres tubes, et donc d'autres bobines, dans l'espace ainsi libéré. On montrera que ces autres bobines alimentées comme le précise l'invention contribuent à l'obtention d'une meilleure linéarité du gradient de champ produit.

On connaît par le document US 5 530 355 une machine de IRM avec un ensemble de bobines de gradient disposées dans un espace annulaire cylindrique, chaque bobine présentant un diamètre inscrit dans une épaisseur de l'espace annulaire et ayant un axe parallèle à la direction du champ principal. L'invention vise à améliorer des machines de ce type.

L'invention a donc pour objet une machine de RMN de type cylindrique circulaire selon la revendication 1. D'autres caractéristiques avantageuses figurent dans les revendications dépendantes.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :

- Figure 1 : une représentation schématique du tunnel d'une machine de RMN comportant un espace annulaire disponible pour recevoir les dispositifs de l'invention ;
- Figure 2 : la modification de la machine de la figure 1 selon l'invention en plan de coupe perpendiculaire au champ principal, c'est-à-dire à l'axe du tunnel ;
- Figure 3 : les représentations schématiques de bobines de gradient réalisées dans chacun des tubes de la figure 2 pour faire des gradients Z, pour faire des gradients X (ou Y) ou pour faire des gradients mixtes XZ (ou YZ) ;
- Figure 4 : la représentation d'un mode particulier de réalisation des éléments d'une bobine de gradient mise en place dans un des tubes ;
- Figures 5a et 5b : des valeurs d'alimentation en courant des différentes bobines, selon leur position dans la machine, et pour une orientation donnée du gradient à mettre en oeuvre.

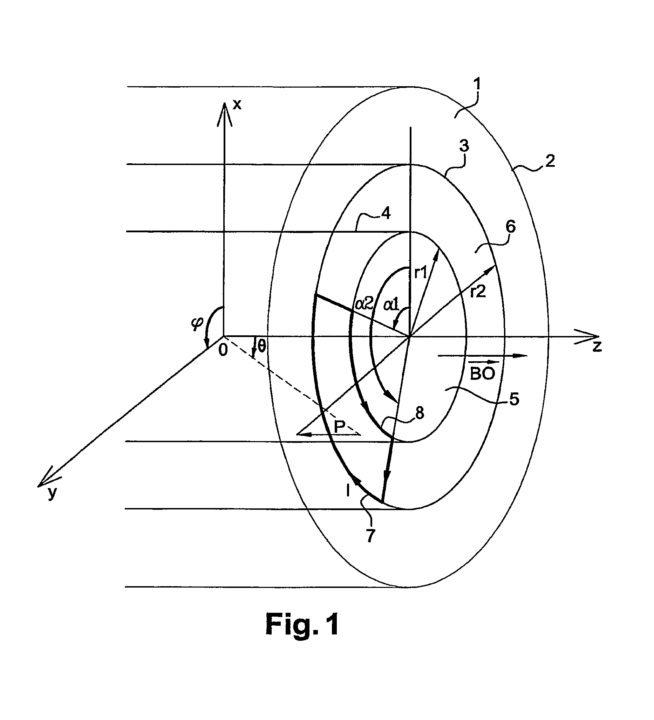

La figure 1 montre très schématiquement une machine de RMN selon l'invention. Cette machine comporte, dans le domaine supraconducteur, une enceinte 1 de cryostat de type cylindrique circulaire et annulaire, tunnel, bordée par une enveloppe extérieure 2 et une enveloppe intérieure 3 métalliques. En pratique, les enveloppes 2 et 3 pourraient être en un matériau non-conducteur, notamment en résine époxy. Cependant pour des raisons de tenue mécanique et d'étanchéité, il s'est avéré que les enveloppes étaient toujours métalliques et conduisaient donc à un déploiement de courants de Foucault néfastes. A l'intérieur du volume circonscrit par ce cryostat est placé un écran 4 délimitant une zone intérieure utile 5, cylindrique circulaire de rayon r1. La bobine contenue dans le cryostat produit un champ homogène et intense B0, dit aussi $B_0$, sensiblement parallèle à l'axe du tunnel.

La machine de l'invention comporte donc un espace annulaire 6 cylindrique circulaire, entre la zone 5 et l'enveloppe 3, destiné à recevoir les dispositifs de production de gradient de champs magnétiques. Dans la pratique, les dispositifs incorporés dans l'espace annulaire 6 produisent des champs magnétiques orientés dans les directions variées de l'espace. Les composantes de ces champs magnétiques qui ne sont pas orientés comme le champ orientateur B0 contribuent au deuxième ordre seulement (et donc de manière négligeable pour les valeurs considérées de B0 et des gradients) à la modification du signal de RMN utile. Ainsi, la seule composante de ces champs magnétiques, produite par les bobines de gradient, qui est intéressante et utile est la composante orientée selon le champ B0. Cette composante utile est appelée traditionnellement composante Bz, ou $B_z$. La machine est repérée par rapport à un référentiel cartésien, l'axe z étant colinéaire à la direction du champ uniforme B0 et parallèle aux génératrices de la machine tunnel. Selon les différents jeux de bobines de gradient alimentés, la composante Bz utile en un lieu verra son amplitude croître en fonction de l'abscisse x d'un plan contenant ce lieu, parallèle au plan yOz pour les gradients X, en fonction de l'ordonnée y d'un plan contenant ce lieu, parallèle au plan xOz pour les gradients Y, ou en fonction de la cote z d'un plan contenant ce lieu, parallèle au plan xOy pour les gradients Z.

La figure 1 montre en particulier la solution préconisée par la thèse identifiée ci-dessus dans laquelle des retours de courant 7 de courants 8 utiles conduisent à la réalisation de bobines à sections sensiblement trapézoïdales, d'ouverture angulaire $\pi/2$, impropres à leur réalisation industrielle, et à une bonne tenue mécanique face aux vibrations.

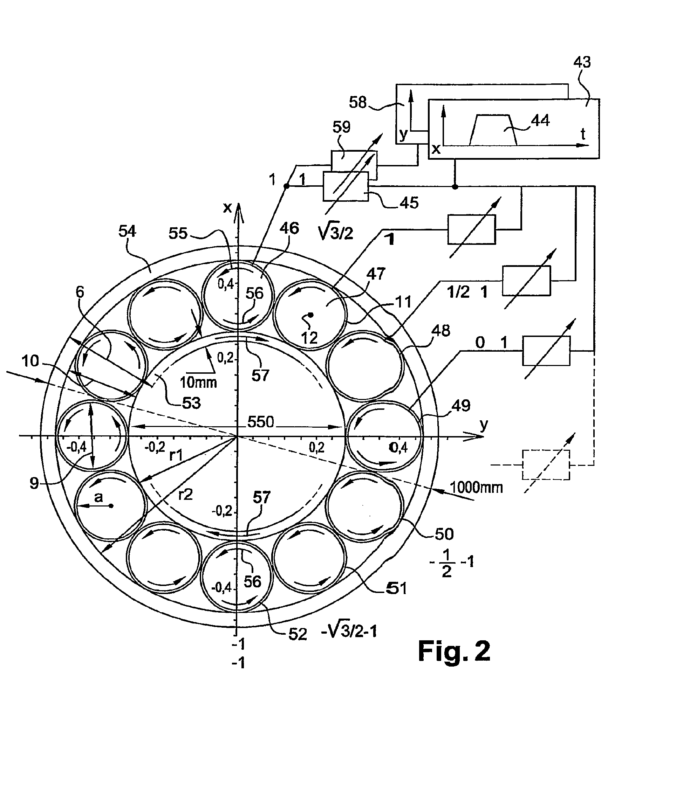

Dans l'invention, figure 2, on a montré l'espace annulaire cylindrique 6 comme comportant des bobines solénoïdales circulaires dont le diamètre 9, de valeur 2a, est inscrit dans une épaisseur 10 de cet espace annulaire 6. On peut admettre dans un premier temps que l'épaisseur 10 de l'espace annulaire est égale à l'épaisseur totale de cet espace 6. Des dispositifs annulaires complémentaires présents à la périphérie intérieure et extérieure de l'espace 6 sont le résultat de perfectionnements souhaités, mais non indispensables. Dans l'exemple représenté, l'espace annulaire 6 est ainsi occupé par douze tubes matérialisés par des enveloppes en matière plastique 11, ou en un autre matériau isolant électriquement. A l'intérieur des tubes 11, des bobines de production de champs magnétiques de gradient sont engagées. Elles seront décrites plus loin. De préférence les tubes sont contigus les uns aux autres. Ils sont répartis ici en une seule nappe, le diamètre de chacun des tubes occupant sensiblement l'épaisseur 10 de l'espace 6. Il serait toutefois envisageable de proposer plusieurs nappes avec des tubes de diamètre réduit.

Selon l'invention, le nombre de tubes est pair, soit 2n, pour constituer les gradients de type X ou Y. Cependant, pour constituer les gradients Z, le nombre de tubes pourrait ne pas être pair.

Selon l'invention, chaque tube est muni d'un jeu de bobines exactement identique à un jeu d'un autre tube. Ce jeu de bobine est capable de produire un gradient Z et un gradient dans une direction choisie perpendiculaire à l'axe z. On montrera ensuite, par la commande des différentes bobines, comment on destine les différentes bobines à produire des gradients d'orientation X ou Y.

Ci-après sont exposées quelques notions de base utiles à la compréhension de l'invention. A l'intérieur d'une sphère magnétiquement vide de centre O et de rayon rmax, chaque composante Bx, By et Bz a son laplacien nul. On a ainsi $\Delta B_z=0$, et Bz a un développement unique en harmoniques sphériques de la forme :

$$B_z(r,\theta,\varphi)/B_0=1+\Sigma^{\infty}_{n=1}(r/r_0)^n[H_nP_n(\cos\theta)+\Sigma^{n}_{m=1}(I^m_n\cos m\varphi+J^m_n\sin m\varphi)W^m_nP^m_n(\cos\theta)]$$

- $B_z$ est complètement décrit par B0, le champ à l'origine O, et les coefficients $H_n$, $I^m_n$ et $J^m_n$.
- $r_o$ est une longueur de référence, par exemple le rayon de la sphère d'intérêt, et
- $W^m_n$ un facteur numérique de pondération introduit par commodité de telle façon que $| W^m_nP^m_n(\cos(\theta)|\leq 1$ comme $|P_n\{\cos(\theta)|$. Dans ces conditions, les coefficients $H_n$, $I^m_n$ et $J^m_n$ donnent directement leur contribution maximum à l'inhomogénéité de $B_z$ sur la sphère de rayon $r_0$.

Si les sources du champ possèdent des propriétés de symétrie, certains termes $H_n$, $I^m_n$ ou et $J^m_n$ seront nuls. Pour un système de courants sources à symétrie de révolution autour de Oz, notamment pour des gradients de type z, le développement de $B_z$ à l'intérieur d'u ne sphère magnétiquement vide se réduit à $B_z(r,\theta,\varphi(p)/B0=1+\Sigma^{\infty}_{n=1}(r/r_0)^nH_nP_n(\cos\theta)$

Si de plus le système source est symétrique ou antisymétrique par rapport au plan xOy, les termes d'ordre impair ou d'ordre pair respectivement seront nuls.

Pour produire un gradient $\partial B_z/\partial z$ on utilisera l'antisymétrie et le développement s'écrit alors $B_z(r,\theta,\varphi)/B_0=\Sigma^{\infty}_{p=0}(r/r_0)^{2p+1}H_{2p+1}P_{2p+1}(\cos\theta)$. Un tel système produisant un champ nul à l'origine, $B_0$ est simplement un champ de référence.

La composante H1 donne la valeur du gradient car le premier terme s'écrit $H_1 z/r_0$ et les $H_{2p+1}$ d'ordre supérieur vont générer des imperfections. En choisissant, comme le précise l'invention, le nombre et les dimensions des bobines, on améliorera la linéarité du gradient en annulant d'abord $H_3$ puis $H_5$, etc jusqu'à ce que les spécifications soient atteintes.

Le cas des systèmes de courants sources générant des gradients $\partial B_z/\partial x$ et $\partial B_z/\partial y$ est un peu plus délicat. On rappelle tout d'abord qu'on ne s'intéresse qu'à la composante $B_z$ du champ pour les raisons expliquées ci-dessus. Par exemple, pour générer un gradient $\partial B_z/\partial x$, le système de courants sources doit être symétrique par rapport aux plans xOy et yOz. Le développement de $B_z$ ne contient plus alors que des termes en $I^{2q+1}{}_{2p+1}$ $B_z\ (r,\theta,\varphi)/B_0=\Sigma^{\infty}{}_{p=0}\ (r/r_0)^{2p+1}\Sigma^{p}{}_{q=0} I^{2q+1}{}_{2p+1} W^{2q+1}{}_{2P+1} P^{2q+1}{}_{2p+1}\ (\cos\theta)\cos(2q+1)\varphi$

Un tel système produisant un champ nul à l'origine, $B_0$ est simplement un champ de référence. La composante $I^1{}_1$ donne le gradient car le premier terme s'écrit $I^1{}_1 x/r_0$ et les $I^{2q+1}{}_{2p+1}$ d'ordre supérieur vont générer des imperfections.

Ceci étant, dans l'invention, on a eu l'idée de refermer les circuits autrement que la manière décrite en référence à la figure 1 qui conduisait à des sections de bobine sensiblement trapézoïdales. On a notamment eu l'idée de réaliser les bobines sous la forme circulaire pour les raisons expliquées plus haut. Puis, en plus, premièrement, on a eu l'idée d'annuler les termes d'ordre $m\geq 3$ en alimentant simultanément plusieurs bobines par des courants d'intensités judicieusement choisies. Deuxièmement on a eu l'idée d'utiliser des bobines pour le gradient X et des bobines pour le gradient Y, certaines bobines pouvant servir simultanément pour les deux types de gradient.

En pratique, pour réaliser un système de gradients suivant le principe d'un ensemble de tubes identiques d'axes parallèles à Oz et équidistants de Oz, il faut pouvoir disposer un nombre pair de tubes, de préférence du plus grand diamètre possible à l'intérieur de l'espace annulaire 6 circonscrit par l'aimant principal (de diamètre 1000 mm environ).

Par ailleurs, le plus grand cylindre inscriptible à l'intérieur de la nappe ou des nappes de tubes doit permettre le passage du patient et des antennes (soit un espace libre de diamètre 550 mm environ).

On a trouvé que la solution à n=12 tubes est de préférence à retenir avec les relations suivantes entre le rayon a des tubes et les rayons r1 et r2 des cylindres tangents à l'intérieur et à l'extérieur des tubes respectivement, et qui délimitent l'espace annulaire 6. En effet pour n=12, la formule suivante pour des tubes strictement contigus : $a = r1(\sin\pi/n)/(1-\sin\pi/n) = r2\ (\sin\pi/n)/(1+\sin\pi/n)$ donne

$a = 0{,}349198.r_1 = 0{,}205605.r_2$
$r_1$=2.863703.a
$r_2$=4,863703.a
$r_2/r_1$=1,698396
$r_1/r_2$=0.588791

On a donc dans un exemple pour des tubes strictement contigus :

$r_1$=275mm a=96mm $r_2$=467mm, ou
$r_2$=450mm a=92,5mm $r_1$=265mm, ou
$r_1$=275mm $r_2$=450mm a=87,5mm, suivant les dimensions que l'on choisit de fixer. Bien entendu, il n'est pas nécessaire que les tubes se touchent mais, pour plus d'efficacité, on cherche à utiliser le maximum de l'espace disponible dans la machine considérée.

Il ne reste plus qu'à trouver le nombre de bobines par tube, leurs dimensions et la densité de courant (valeur et forme ) pour obtenir la linéarité souhaitée en dissipant le minimum de puissance (on peut aussi chercher à limiter la self pour satisfaire des spécifications de vitesse de balayage). Les contraintes et choix effectués dans l'invention sont de loger les bobines de gradient X (ou Y) et les bobines de gradient Z dans le même tube, tous les tubes étant identiques pour faciliter une production industrielle. On choisit également, pour un gradient Z, de pulser toutes les bobines Z des tubes avec le même courant +I ou -I suivant qu'elles sont d'un côté ou de l'autre du plan xOy. Pour un gradient X, on pulse les deux tubes X dont l'axe est dans le plan xOz avec le courant +I pour l'un et -I pour l'autre, les quatre tubes premiers voisins de ces deux tubes avec + ou $-I\sqrt{3}/2$ et les quatre tubes seconds voisins avec + ou -I/2, soit 10 tubes produisant en tout 3 fois le gradient des deux premiers, en assurant ainsi l'annulation de tous les termes d'inhomogénéité d'ordre $m\geq 3$, les premiers termes non nuls apparaissant à l'ordre m=11. Pour un gradient Y, on procède de façon similaire : il suffit de remplacer « le plan xOz » par « le plan yOz » dans la phrase précédente. Si l'on veut réaliser simultanément un gradient X et un gradient Y, certaines bobines devront être alimentées par la somme algébrique des courants correspondants aux deux gradients.

On peut alimenter toutes les bobines transportant le même courant par le même amplificateur en les connectant convenablement (en respectant les + et -) en série mais on peut choisir d'autres combinaisons pour avoir des amplificateurs moins puissants. Par exemple, on peut pulser par tube ou par demi-tube les bobines Z d'une part et les bobines XY d'autre part, ce qui conduit à 24 ou 48 amplificateurs respectivement.

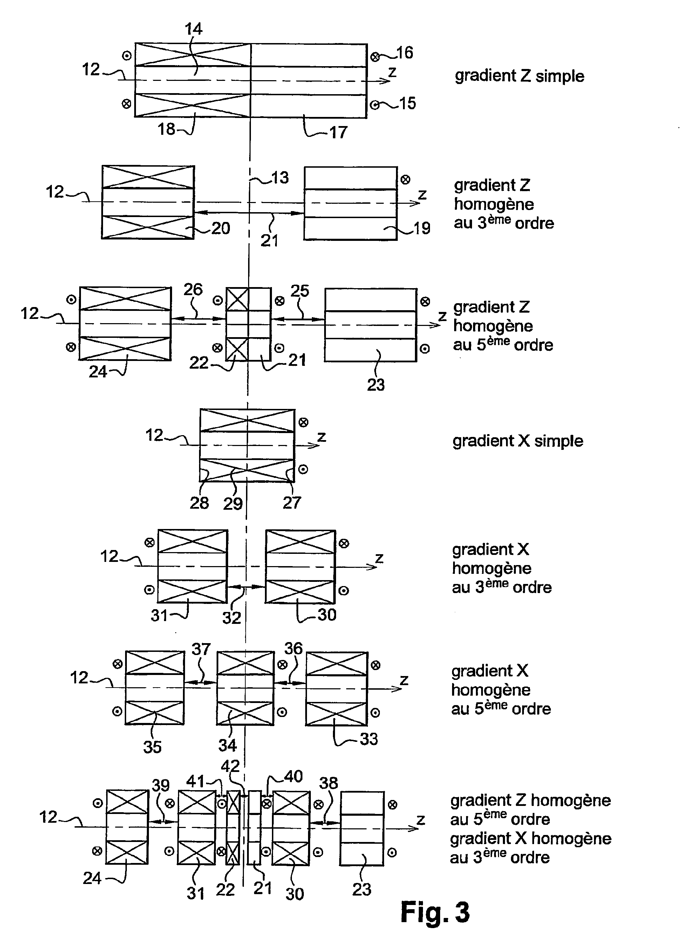

La figure 3 montre comment réaliser des bobines de gradient à engager dans les tubes tels que 11. La figure 3 montre des bobines solénoïdales circulaires dont les axes 12 de révolution sont placés au centre des tubes 11 et sont parallèles à l'axe z. Sur la figure 3, on a figuré la trace 13 du plan xOy central de la machine. Les bobines présentées sur la figure 3 montrent que l'espace intérieur 14 des bobines peut être libre. On verra plus loin comment cet espace peut être occupé, et/ou servir d'autre part pour le refroidissement de la bobine. Les bobines comportent, selon le sens du courant qui y circule, des indications en pointe de flèche 15 ou en empennage de flèche 16 montrant le sens de rotation du courant dans la bobine.

Pour fabriquer un gradient Z simple, il suffit, dans chaque tube, de deux éléments de bobine 17 et 18, symétriques par rapport au plan 13, et dans lesquels le courant passe de manière respectivement contrarotative. L'ensemble de ces éléments 17 et 18 produit un gradient Z simple, c'est-à-dire homogène à l'ordre 1 (H3, H5,..., ne sont pas nuls). La distribution régulière de tous les tubes autour de l'axe Oz assure que les seuls termes $I_n^m$ ou $J_n^m$ non nuls sont tels que n+m est impair, m étant un multiple entier du nombre de tubes et toujours ≤n, ce qui, pour 12 tubes, les rend complètement négligeables. Par contre, il reste des termes d'inhomogénéité en Hn. On peut obtenir un gradient Z homogène au troisième ordre ($H_3$=0) si on remplace les deux éléments contigus 17 et 18 par deux éléments 19 et 20, séparés l'un de l'autre d'un espace longitudinal 21 dans le tube. De même, pour obtenir un gradient Z homogène au cinquième ordre ($H_3$=$H_5$=0), on remplace l'ensemble des deux éléments 19 et 20 par un ensemble de quatre éléments 21 et 22, et 23 et 24. Les deux éléments 21 et 22 sont contigus et contrarotatifs. Les deux éléments 23 et 24, eux aussi contrarotatifs, sont encore plus séparés l'un de l'autre que ne l'étaient les éléments 19 et 20. Les inhomogénéités résultent alors des termes restants $H_7$, $H_9$,... et il est en pratique largement suffisant de ne pas compliquer la structure pour améliorer encore l'homogénéité, ce qui serait néanmoins possible, suivant le même principe, en augmentant par exemple le nombre de bobines. Le tableau ci-après résume le principe de l'obtention de l'homogénéité des gradients Z selon l'invention et correspond au cas de 3 tubes seulement, régulièrement répartis (dans le cas pratique à 12 tubes les $I_n^m$ ou $J_n^m$ non nuls apparaîtraient seulement à partir de m=12 comme indiqué ci-dessus) :

| | | | | | | | | | |
|---|---|---|---|---|---|---|---|---|---|
| $\cancel{H_0}$ | | | | | | | | | |
| $H_1$ | $\cancel{I_1^1}$ | | | | | | | | |
| | $\cancel{J_1^1}$ | | | | | | | | |
| $\cancel{H_2}$ | $\cancel{I_2^1}$ | $\cancel{I_2^2}$ | | | | | | | |
| | $\cancel{J_2^1}$ | $\cancel{J_2^2}$ | | | | | | | |
| $\cancel{H_3}$ | $\cancel{I_3^1}$ | $\cancel{I_3^2}$ | $\cancel{I_3^3}$ | | | | | | |
| | $\cancel{J_3^1}$ | $\cancel{J_3^2}$ | $\cancel{J_3^3}$ | | | | | | |
| $\cancel{H_4}$ | $\cancel{I_4^1}$ | $\cancel{I_4^2}$ | $I_4^3$ | $\cancel{I_4^4}$ | | | | | |
| | $\cancel{J_4^1}$ | $\cancel{J_4^2}$ | $J_4^3$ | $\cancel{J_4^4}$ | | | | | |
| $\cancel{H_5}$ | $\cancel{I_5^1}$ | $\cancel{I_5^2}$ | $\cancel{I_5^3}$ | $\cancel{I_5^4}$ | $\cancel{I_5^5}$ | | | | |
| | $\cancel{J_5^1}$ | $\cancel{J_5^2}$ | $\cancel{J_5^3}$ | $\cancel{J_5^4}$ | $\cancel{J_5^5}$ | | | | |
| $\cancel{H_6}$ | $\cancel{I_6^1}$ | $\cancel{I_6^2}$ | $I_6^3$ | $\cancel{I_6^4}$ | $\cancel{I_6^5}$ | $\cancel{I_6^6}$ | | | |
| | $\cancel{J_6^1}$ | $\cancel{J_6^2}$ | $J_6^3$ | $\cancel{J_6^4}$ | $\cancel{J_6^5}$ | $\cancel{J_6^6}$ | | | |
| $H_7$ | $\cancel{I_7^1}$ | $\cancel{I_7^2}$ | $\cancel{I_7^3}$ | $\cancel{I_7^4}$ | $\cancel{I_7^5}$ | $I_7^6$ | $\cancel{I_7^7}$ | | |
| | $\cancel{J_7^1}$ | $\cancel{J_7^2}$ | $\cancel{J_7^3}$ | $\cancel{J_7^4}$ | $\cancel{J_7^5}$ | $J_7^6$ | $\cancel{J_7^7}$ | | |
| $\cancel{H_8}$ | $\cancel{I_8^1}$ | $\cancel{I_8^2}$ | $I_8^3$ | $\cancel{I_8^4}$ | $\cancel{I_8^5}$ | $\cancel{I_8^6}$ | $\cancel{I_8^7}$ | $\cancel{I_8^8}$ | |
| | $\cancel{J_8^1}$ | $\cancel{J_8^2}$ | $J_8^3$ | $\cancel{J_8^4}$ | $\cancel{J_8^5}$ | $\cancel{J_8^6}$ | $\cancel{J_8^7}$ | $\cancel{J_8^8}$ | |
| $H_9$ | $\cancel{I_9^1}$ | $\cancel{I_9^2}$ | $\cancel{I_9^3}$ | $\cancel{I_9^4}$ | $\cancel{I_9^5}$ | $I_9^6$ | $\cancel{I_9^7}$ | $\cancel{I_9^8}$ | $\cancel{I_9^9}$ |
| | $\cancel{J_9^1}$ | $\cancel{J_9^2}$ | $\cancel{J_9^3}$ | $\cancel{J_9^4}$ | $\cancel{J_9^5}$ | $J_9^6$ | $\cancel{J_9^7}$ | $\cancel{J_9^8}$ | $\cancel{J_9^9}$ |

Les termes barrés d'une croix x sont nuls à cause de l'antisymétrie par rapport au plan xOy, ceux barrés \ sont nuls à cause de la répartition régulière des trois tubes alimentés de façon identique et ceux barrés / sont nuls à cause de la disposition des bobines dans chaque tube (homogénéité au cinquième ordre dans cet exemple).

En ce qui concerne le gradient X simple, il peut être obtenu à l'aide d'un seul élément de bobine 27 centré sur le plan médian 13. On obtient dans ce cas un gradient X homogène au premier ordre. On notera que pour le gradient X, un pseudo élément de bobine 28 gauche par rapport au plan 13 est parcouru par un courant de même sens qu'un pseudo élément de bobine 29 à droite du plan 13 et formant ensemble l'élément de bobine 27. Pour obtenir un gradient X homogène au troisième ordre, il faut, dans les tubes, mettre en place, à la place de l'élément de bobine 27, deux éléments de bobine 30 et 31, séparés par un espace 32 l'un de l'autre. Les courants dans les éléments 30 et 31 tournent dans le même sens. De même pour obtenir un gradient X homogène au cinquième ordre, il faut remplacer les éléments 30 et 31 par un triplet d'éléments 33, 34, 35, séparés l'un de l'autre respectivement par des espaces identiques 36 et 37. Le tableau ci-après résume le principe de l'obtention de l'homogénéité des gradients Z selon l'invention pour un ensemble de 12 tubes :

| | | | | | | | | | |
|---|---|---|---|---|---|---|---|---|---|
| $H_0$ | | | | | | | | | |
| $H_1$ | $I_1^1$ | | | | | | | | |
| | $J_1^1$ | | | | | | | | |
| $H_2$ | $I_2^1$ | $I_2^2$ | | | | | | | |
| | $J_2^1$ | $J_2^2$ | | | | | | | |
| $H_3$ | $I_3^1$ | $I_3^2$ | $I_3^3$ | | | | | | |
| | $J_3^1$ | $J_3^2$ | $J_3^3$ | | | | | | |
| $H_4$ | $I_4^1$ | $I_4^2$ | $I_4^3$ | $I_4^4$ | | | | | |
| | $J_4^1$ | $J_4^2$ | $J_4^3$ | $J_4^4$ | | | | | |
| $H_5$ | $I_5^1$ | $I_5^2$ | $I_5^3$ | $I_5^4$ | $I_5^5$ | | | | |
| | $J_5^1$ | $J_5^2$ | $J_5^3$ | $J_5^4$ | $J_5^5$ | | | | |
| $H_6$ | $I_6^1$ | $I_6^2$ | $I_6^3$ | $I_6^4$ | $I_6^5$ | $I_6^6$ | | | |
| | $J_6^1$ | $J_6^2$ | $J_6^3$ | $J_6^4$ | $J_6^5$ | $J_6^6$ | | | |
| $H_7$ | $I_7^1$ | $I_7^2$ | $I_7^3$ | $I_7^4$ | $I_7^5$ | $I_7^6$ | $I_7^7$ | | |
| | $J_7^1$ | $J_7^2$ | $J_7^3$ | $J_7^4$ | $J_7^5$ | $J_7^6$ | $J_7^7$ | | |
| $H_8$ | $I_8^1$ | $I_8^2$ | $I_8^3$ | $I_8^4$ | $I_8^5$ | $I_8^6$ | $I_8^7$ | $I_8^8$ | |
| | $J_8^1$ | $J_8^2$ | $J_8^3$ | $J_8^4$ | $J_8^5$ | $J_8^6$ | $J_8^7$ | $J_8^8$ | |
| $H_9$ | $I_9^1$ | $I_9^2$ | $I_9^3$ | $I_9^4$ | $I_9^5$ | $I_9^6$ | $I_9^7$ | $I_9^8$ | $I_9^9$ |
| | $J_9^1$ | $J_9^2$ | $J_9^3$ | $J_9^4$ | $J_9^5$ | $J_9^6$ | $J_9^7$ | $J_9^8$ | $J_9^9$ |

Les termes barrés d'une croix x sont nuls à cause de la symétrie par rapport aux plans xOy et yOz, ceux barrés \ sont nuls à cause de la répartition des courants dans les 10 tubes alimentés comme indiqué plus haut (2 avec $\pm$I, 4 avec $\pm$I$\sqrt{3}$/2 et 4 avec $\pm$I/2) et ceux barrés / sont nuls à cause de la disposition des bobines dans chaque tube (homogénéité au troisième ordre dans cet exemple).

Selon une dernière représentation de l'invention figurant au bas de la figure 3, on prévoit de constituer un gradient mixte: gradient Z homogène au cinquième ordre et gradient X homogène au troisième ordre, en combinant le gradient Z homogène au cinquième ordre avec le gradient X homogène au troisième ordre. En pratique, on modifie les écarts 25 et 26 pour y introduire les bobines 30 et 31. L'espace 32 lui-même est agrandi pour y recevoir les bobines 21 et 22. Pour des raisons pratiques, les bobines 21 et 22 sont elles-mêmes écartées l'une de l'autre d'un espace imposé permettant les retours de courant et la mise en place d'éléments mécaniques d'installation. En définitive, il reste maintenant des écarts 38 et 39 entre les bobines 30 et 23 d'une part et 31 et 24 d'autre part, et des écarts 40 et 41 entre les bobines 21 et 30 d'une part et 22 et 31 d'autre part. L'espace central 42 dans un exemple est limité à 20 mm.

En agissant ainsi, on est capable d'obtenir un gradient Z homogène au cinquième ordre et un gradient X homogène au troisième ordre. On notera que cette disposition avantage l'homogénéité du gradient Z par rapport aux homogénéités des gradients X (ou Y). Ceci peut être toléré dans la mesure où le gradient Z doit bénéficier, pour diverses raisons, d'une homogénéité supérieure.

Si, par contre, l'homogénéité du gradient X est insuffisante, on peut, selon l'invention, prévoir de l'augmenter et d'éliminer notamment les inhomogénéités du cinquième ordre en utilisant trois bobines 33, 34 et 35 dans chaque tube. Il n'y a alors plus de place suffisante pour les bobines réalisant le gradient Z dans le même tube, mais celui-ci peut être réalisé par des bobines classiques comme expliqué plus loin.

Pour l'alimentation des bobines 30 et 31 ou 33, 34 et 35 suivant l'homogénéité réalisée, la figure 2 montre que, pour un gradient X, un circuit électronique 43 produit une impulsion temporelle 44 ayant la forme (temps de montée, temps de descente) et la durée requise par une séquence d'imagerie à mettre en oeuvre avec la machine de RMN. Le signal 44 représentatif de l'impulsion est introduit dans un amplificateur 45 à gain variable et commandé.

La commande appliquée sur l'amplificateur 45, produite par un système informatique qui gère les séquences, provoque l'application d'un courant nominal multiplié par un coefficient qui vaut ici 1 pour les bobines situées dans un tube 46 situé dans le plan xOz.

Un tube 47 contigu au tube 46 dont l'axe, ici 12, est situé dans un plan passant par l'axe z et incliné de $\pi/6$ par rapport au plan xOz est alimenté par un courant multiplié par un coefficient valant $\sqrt{3}/2$. Pour un tube 48 contigu au tube 47 et encore décalé de ce dernier de $\pi/6$, le courant est multiplié par1/2. Pour un tube 49 contigu au tube 48, et situé dans un plan yOz, le coefficient vaut 0. Pour un tube 50 symétrique du tube 48, le coefficient vaut -1/2, pour un tube 51 symétrique du tube 47, il vaut $-\sqrt{3}/2$, et pour un tube 52 symétrique du tube 46 par rapport à l'axe Z, le coefficient vaut -1. Pour les tubes situées à gauche de la figure et symétriques des tubes 46 à 52 par rapport au plan xOz, les valeurs de coefficient sont les mêmes (négatives en dessous de l'axe Y, positives au dessus de l'axe Y).

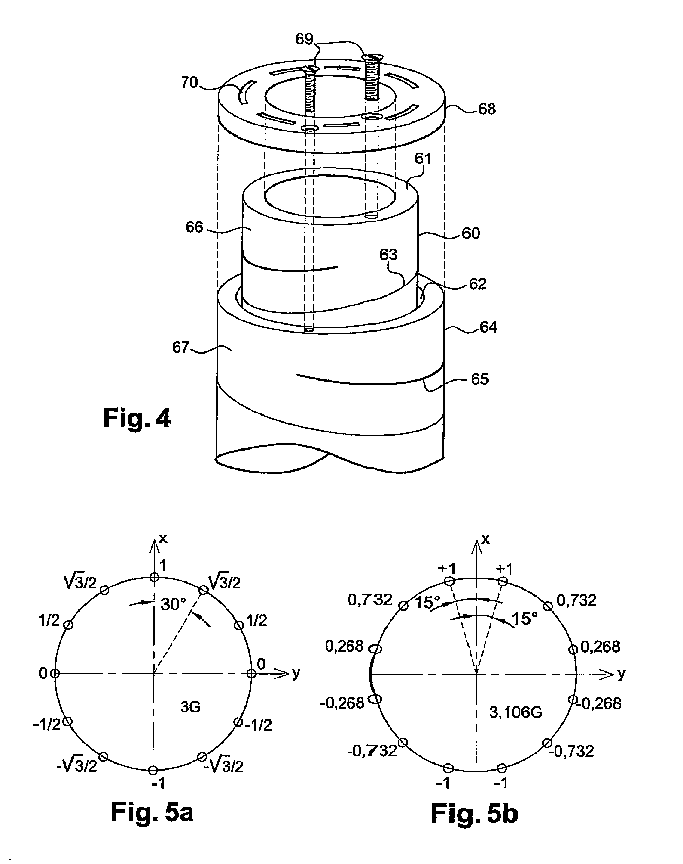

Le courant dans une bobine est ainsi proportionnel au cosinus de l'angle de repérage du tube qui la contient sur le pourtour de l'espace circulaire. Cette répartition des courants est rappelée à la figure 5a mais on peut utiliser une variante décalée de 15° représentée à la figure 5b.

Pour un gradient Z, les bobines Z, c'est-à-dire les bobines 21, 22 et 23 et 24 de chacun des tubes 46 à 52 (ainsi que les symétriques de la partie gauche de l'axe x sur la figure 2), sont commandées avec un courant nominal.

En variante, si le gradient X doit être homogène à plus que le troisième ordre, on peut prévoir de remplir les tubes 46 à 52 et leurs symétriques par des bobines uniquement destinées à produire le gradient X (ou Y). Dans ce cas, pour la réalisation des bobines de gradients produisant le gradient Z, on se réserve deux espaces situés de part et d'autre dans l'espace 6 de l'épaisseur utile 10. Il s'agit, figure 2, des espaces 53 et 54. Dans ce cas, ces espaces sont utilisés pour y mettre des bobines de gradient Z de type annulaire connu tel que décrit dans les documents cités ci-dessus.

Dans le cas où la mise en oeuvre des bobines mixtes dans le tube est possible, il peut convenir d'éliminer les effets des courants de Foucault produits par les gradients Z, plus importants que pour les gradients X. Dans ce cas, on place dans l'espace 53 (ou dans l'espace 54 ou éventuellement dans les deux) une bobine de gradient Z de compensation. Cette bobine est du type de celui décrit dans le deuxième document de brevet cité ci-dessus. Sur la figure 2, on a montré alors, un effet particulièrement intéressant de la structure de l'invention si la bobine de compensation est placée dans l'espace 53. En effet, pour le gradient Z, dans les bobines comprises dans les tubes, les courants, marqués par des flèches telles que 55 et 56, sont tous dans un sens donné (pour une position donnée par rapport au plan 13 de la machine). Cette direction 55 ou 56, selon le côté diamétralement opposé de la bobine que l'on considère, est de même sens ou de sens opposé au sens 57 du courant qui circule dans une bobine de gradient Z classique de compensation. On constate alors un effet particulièrement bénéfique, en ce sens que les sens 56 et 57 sont de même sens (ou bien il s'agirait des sens 55 et 57 compte tenu des différentes répartitions des courants dans les différentes bobines). Il en résulte que le champ de compensation contribue à augmenter le gradient de champ, tout en conduisant à la suppression des courants de Foucault dans les enveloppes 2 et 3 du cryostat 1. En définitive, avec la structure ainsi préconisée, on obtient un même gradient compensé avec moins de puissance électrique dissipée dans les bobines de gradient et dans les bobines de compensation.

En ce qui concerne les bobines de compensation des effets des courants de Foucault dues aux bobines de gradient X (ou Y), on peut montrer que du fait de la configuration du champ produit, les courants de Foucault sont plus faibles que pour les gradients de structure décrite dans les documents cités et qu'on peut se dispenser de les compenser.

On a présenté jusqu'ici les bobines concourant à la création du gradient X. Bien entendu, par rotation de l'ensemble de 90°, on peut prévoir que les mêmes bobines serviront pour la création des gradients de champ Y. En pratique, la symétrie autour des plans xOz et yOz conduit à retenir un nombre de tubes multiple de 4 mais ce n'est pas absolument nécessaire, on verra plus loin pourquoi douze tubes est une solution préférée.

Si les impulsions 44 de gradient selon un axe x sont simultanées aux impulsions de gradient selon un autre axe y, les amplificateurs de certains tubes devront être commandés par un ordre composite approprié produit par le séquenceur qui établit les séquences d'imagerie.

Il est à noter cependant qu'en agissant ainsi, on obtient le résultat remarquable que, d'une part, tous les tubes 46 à 52 et leurs symétriques de l'autre côté du plan xOz sont munis d'un même jeu de bobines, celui du bas de la figure 3, et que d'autre part chaque groupe de bobines est commandé par un amplificateur. Un amplificateur servant à alimenter les bobines 21,22, 23 et 24 de gradient Z (en prenant soin d'inverser le sens du courant selon qu'il s'agit des bobines situées en amont ou en aval le long du champ B0), et un autre amplificateur sert à alimenter les éléments 30 et 31 formant le gradient X ou Y. Les amplitudes des courants dans ces bobines dépendent du repérage de la position dans l'espace 10 du tube 11 qui les contient. Pour douze tube, on a donc mis en place 24 amplificateurs. On peut prévoir un nombre plus grand d'amplificateurs moins puissants comme expliqué plus haut.

La figure 4 montre un exemple de réalisation d'un élément de bobine tel que 17 à 18, 21 à 24, 27, 30 à 31, ou 33 à 35. Une telle bobine est constituée d'un ensemble de spires hélicoïdales formé à partir de manchons tubulaires. Par exemple, un manchon 60 en cuivre, pur parce qu'il n'a pas besoin de supporter des contraintes mécaniques élevées, bénéficie ainsi d'une conductivité élevée. Dans un exemple, une épaisseur 61 d'un tel manchon vaut 10 mm. Un manchon 60 est placé dans une machine d'électroérosion qui réalise dans la totalité de l'épaisseur de la paroi de ce tube 60 un sillon 63 hélicoïdal. Le sillon est débouchant de chaque côté de la paroi. Dans un exemple, le sillon a une épaisseur d'un dixième de mm. On réalise ainsi facilement des spires à profil rectangulaire. Pour éviter que la structure ainsi réalisée ne se fragilise, on remplit les rainures 63 hélicoïdales avec une colle étanche chargée de billes de verre, de façon à maintenir les écarts entre les spires malgré la faible dureté de la colle.

Le manchon 60 peut être imbriqué dans un autre manchon 64 préparé exactement de la même façon, mais avec un pas de rainure hélicoïdale 65 inversé, en ménageant un espace annulaire 62 pour le passage d'un fluide de refroidissement. Dans un exemple, l'épaisseur de cet espace est 1 mm. En pratique, les rainures 63 et 65 ne sont pas réalisées jusqu'à l'extrémité des manchons 60 ou 64, de sorte que subsistent aux extrémités de chacun de ceux-ci des anneaux terminaux tels que 66 et 67. Le courant qui passe dans les spires du manchon 60 est récupéré par l'anneau terminal 66 qui lui-même est connecté à une bague 68 connectée à l'anneau terminal 67 du manchon 64 dans lequel le manchon 60 est glissé justement. Le courant à l'autre extrémité des spires du manchon 64 est récupéré de la même façon et est injecté dans l'anneau terminal d'un manchon suivant et ainsi de suite. Les manchons 60, 64 et suivants sont ainsi engagés les uns dans les autres à la manière des poupées russes. D'un manchon à l'autre, les courants sont conduits par une bague telle que 68 reliant entre eux deux anneaux terminaux adjacents. Les bagues 68 servent d'une part à assurer la continuité électrique et d'autre part au maintien mécanique des manchons formant l'élément de bobine recherché au moyen par exemple de vis 69. On peut empiler ainsi un nombre pair (4 par exemple) de manchons les uns dans les autres pour que les connexions terminales soient du même côté ou un nombre impair de manchons (5 par exemple) pour que les connexions terminales soient de chaque coté de la bobine. On notera que la contribution au gradient de champ produit par l'élément de bobine est d'autant plus grande que le manchon est un manchon de plus grand diamètre.

Les bagues telles que 68 sont par ailleurs percées par des orifices en segment circulaire tel que 70. Les orifices 70 servent à faire passer un liquide de refroidissement isolant, par exemple une huile caloportrice. Ce liquide isolant entrant dans le tube 11 passe en parallèle dans l'espace annulaire situé entre les manchons 60 et 64 ou 64 et suivant et ainsi de suite. A l'autre extrémité, le fluide de refroidissement se répand dans le tube 11 qui comporte l'élément ainsi refroidi et va refroidir en aval un autre élément situé dans le même tube. On peut montrer qu'en agissant ainsi, on est capable à la fois de produire une grande puissance de gradient et d'avoir une grande faculté de refroidissement.

Pour régler l'homogénéité et l'intensité des gradients, on dispose non seulement des dimensions des bobines mais du nombre et de la répartition des spires 63 et 65 que chacun des manchons de chacun des éléments de ces bobines contiennent. On peut prévoir ainsi plus ou moins de manchons, et des pas d'hélices 63 ou 65 plus ou moins inclinés.

Sur les figures 5a et 5b, on a montré d'une manière comparative la répartition des tubes selon ce qui était décrit précédemment, figure 5a, et une autre répartition de ces tubes dans laquelle tout l'ensemble est décalé de 15°. Dans le cas de la figure 5b, pour obtenir un gradient X, il convient d'appliquer sur le coefficient multiplicateur des amplificateurs des tubes les plus proches du plan xOz des coefficients +1 ou -1 selon que l'abscisse du tube est positive ou négative. Les quatre tubes adjacents à ces quatre premiers tubes sont affectés du coefficient multiplicateur 0,732 et du signe correspondant selon que leur abscisse est positive ou négative. Les quatre tubes situés au plus près symétriquement par rapport au plan yOz sont affectés du coefficient 0,268 ou -0,268 selon que leur abscisse est positive ou négative. Pour obtenir des gradients Y, il suffit de décaler l'ensemble de 90°.

En agissant avec la structure de la figure 5b, dans laquelle les 12 tubes contribuent à la production du gradient (et non pas seulement 10 tubes comme dans la figure 5a), le gradient produit est 3,106 fois le gradient produit par les bobines sommitales. Le rapport entre la puissance électrique mise en jeu et l'amplitude du gradient produit n'est toutefois pas modifié ; il est identique dans les deux cas. La structure de la figure 5b permet néanmoins, pour des amplificateurs susceptibles de délivrer un courant nominal, de produire un gradient ayant une amplitude maximale 3% plus élevée.

La justification de ces résultats est la suivante.

Dans le cadre du calcul de la distribution des courants dans les tubes de gradient x ou y, on choisit un gradient x a 2n tubes équidistants de l'axe Oz et régulièrement répartis, c'est-à-dire séparés angulairement de $\frac{\pi}{n}$.

Deux possibilités sont à envisager pour respecter les symétries requises par ailleurs.

- cas 1 : l'axe *Ox* coupe l'axe de l'un des tubes ;
- cas 2 : l'axe *Ox* passe entre deux tubes consécutifs, à égale distance de ceux-ci.

On notera que pour un gradient y la situation est identique mais par rapport à l'axe $Oy \perp Ox$.

Si $n$ est pair, soit un nombre total de tubes multiple de 4 (4, 8, 12...), on se trouve dans le même cas pour le gradient x et pour le gradient y. Par contre, si $n$ est impair (nombre total de tubes 2, 6, 10, 14...), on se trouve dans l'un des cas pour le gradient x et dans l'autre cas pour le gradient y.

Les principaux résultats obtenus sont ici présentés pour un gradient x.

Pour annuler les termes $I_{2p+1}^{2q+1}$ d'ordre $2q + 1 = 3$ il faut au moins 6 tubes ($n \geq 3$).

Dans le cas 1, il faut pulser les 2 tubes que coupe l'axe *Ox* avec un courant $\pm I$ (+ pour le tube situé d'un côté du plan *yOz*, - pour l'autre, N. B. : cette convention pour ± est utilisée dans toute la suite) et les 4 tubes adjacents (2 de part et d'autre de chacun des tubes précédents) avec $\pm\left(-\dfrac{1}{2\cos\dfrac{3\pi}{n}}\right)I$ ,par exemple $\pm\dfrac{I}{2}$ pour $n=3$, pour $\pm\dfrac{I}{\sqrt{2}}$ pour $n=4$.

Dans le cas 2, pour $n = 3$, il faut pulser les 4 tubes les plus proches de l'axe *Ox* avec un courant $\pm I$. Pour $n > 3$, il faut pulser les 4 tubes les plus proches de l'axe *Ox* avec un courant $\pm I$ et les 4 suivants avec $\pm\left(-\dfrac{\cos\dfrac{3\pi}{2n}}{\cos\dfrac{9\pi}{2n}}\right)I$.

Il faut noter que l'on annule aussi d'autres $I_{2p+1}^{2q+1}$ d'ordres $2q + 1$ plus élevés que 3 mais pas l'ordre 5.

Une caractéristique importante de l'invention est que pour $n \geq 5$ , soit à partir de 10 tubes et donc pour le nombre préféré de 12, on peut annuler les $I_{2p+1}^{2q+1}$ simultanément pour $2q + 1 = 3$ et $2q + 1 = 5$, ce qui entraîne encore d'autres annulations pour des ordres $2q + 1$ plus élevés (dans le cas de 12 tubes, tous les ordres $2q + 1 \leq 10$ sont ainsi annulés).

Pour ce faire, dans le cas 1, il faut pulser les 2 tubes que coupe l'axe *Ox* avec un courant $\pm I$, les 4 tubes adjacents avec $\pm\left(\dfrac{\cos\dfrac{6\pi}{n}-\cos\dfrac{10\pi}{n}}{2\left(\cos\dfrac{3\pi}{n}\cos\dfrac{10\pi}{n}-\cos\dfrac{5\pi}{n}\cos\dfrac{6\pi}{n}\right)}\right)I$ et les 4 tubes adjacents suivants avec

$$\pm\left(\frac{\cos\dfrac{5\pi}{n}-\cos\dfrac{3\pi}{n}}{2\left(\cos\dfrac{3\pi}{n}\cos\dfrac{10\pi}{n}-\cos\dfrac{5\pi}{n}\cos\dfrac{6\pi}{n}\right)}\right)I,$$

ce qui donne pour $n = 6$, soit 12 tubes, $\pm\dfrac{\sqrt{3}}{2}I$ et $\pm\dfrac{I}{2}$.

On notera que la coïncidence numérique avec le cosinus de l'angle qui repère le tube n'intervient que pour ce cas de 12 tubes et n'est donc pas une propriété générale.

Dans le cas 2, il faut pulser les 4 tubes les plus proches de l'axe *Ox* avec un courant $\pm I$, les 4 tubes adjacents avec

$$\pm\left(\frac{\cos\frac{5\pi}{2n}\cos\frac{15\pi}{2n}-\cos\frac{3\pi}{2n}\cos\frac{25\pi}{2n}}{\cos\frac{9\pi}{2n}\cos\frac{25\pi}{2n}-\cos^{2}\frac{15\pi}{2n}}\right)I$$

et pour $n > 5$ les 4 tubes adjacents suivants avec

$$\pm\left(\frac{\cos\frac{3\pi}{2n}\cos\frac{15\pi}{2n}-\cos\frac{5\pi}{2n}\cos\frac{9\pi}{2n}}{\cos\frac{9\pi}{2n}\cos\frac{25\pi}{2n}-\cos^{2}\frac{15\pi}{2n}}\right)I,$$

soit pour $n = 6$ (12 tubes) $\pm 0.732051\ I$ et $0.267949\ I$ qu'on peut arondir à la troisième décimale.

Selon l'invention, on a donc bien été capable d'avoir des bobines de gradient X, par exemple celle contenue dans les tubes 47 et 48, contribuant, parce qu'elles sont alimentées par des courants supplémentaires (du fait de l'amplificateur 59), à la production d'un gradient Y. De ce fait on peut dire que les bobines d'un premier ensemble de gradients comporte des bobines du deuxième ensemble de gradients. Ceci est vrai pour la figure 5a. Pour la figure 5b, les bobines du premier ensemble produisant le premier gradient X sont les bobines du deuxième ensemble produisant le deuxième gradient Y : les bobines du premier ensemble comportent toutes les bobines du deuxième ensemble et réciproquement.

## Revendications

1. Machine de RMN de type cylindrique circulaire (1-3) comportant un espace annulaire cylindrique (6) occupé par des bobines solénoïdales circulaires (21-24, 30, 31) dont le diamètre (2a) est inscrit dans une épaisseur (10) de l'espace annulaire et dont l'axe est parallèle à la direction z du champ principal, ces bobines comprenant un premier ensemble de bobines solénoïdales circulaires aptes à produire un premier gradient de champ X dans une première direction radiale x de la machine, ces bobines du premier ensemble possédant entre elles une symétrie de réalisation par rapport à un premier plan xOz qui est radial à la machine et qui contient cette direction x, et un deuxième ensemble de bobines solénoïdales circulaires aptes à produire un deuxième gradient de champ Y dans une deuxième direction radiale y de la machine, la première direction x étant perpendiculaire à la deuxième direction y, le deuxième ensemble étant identique au premier ensemble et étant présenté dans la machine dans une position tournée de 90° par rapport à un axe de révolution Oz de la machine qui est parallèle à la direction z du champ principal, ces bobines du deuxième ensemble présentant entre elles une symétrie de réalisation par rapport à un deuxième plan radial yOz perpendiculaire audit premier plan xOz, les bobines solénoidales circulaires desdits premier et deuxième ensembles de bobines solénoïdales circulaires étant réparties selon le pourtour de l'espace annulaire en un nombre pair de 2n arrangements de bobines solénoïdales coaxiales identiques engagées dans des tubes et équidistantes de l'axe de révolution Oz, avec n entier, de telle manière que l'ensemble des bobines présente une symétrie par rapport aux plans xOz et yOz, la machine comportant des amplificateurs pour alimenter l'ensemble des bobines solénoïdales circulaires lesdits premier et deuxième ensembles, **caractérisée en ce que** les mêmes bobines solénoïdales circulaires servent pour la création du gradient de champ X et du gradient de champ Y, et **en ce que** des moyens sont prévus pour alimenter lesdites mêmes bobines solénoïdales circulaires simultanément par des combinaisons de courants pour produire un gradient de champ X et un gradient de champ Y, le courant dans une bobine étant proportionnel au cosinus de l'angle du tube qui contient la bobine sur le pourtour de l'espace annulaire.

2. Machine selon la revendication 1, **caractérisée en ce qu'**une bobine solénoïdale circulaire (21-24) dont le diamètre est inscrit dans l'espace annulaire cylindrique et qui contribue à produire un gradient de champ Z dans une première direction z parallèle à la direction de champ principal est coaxiale avec une autre bobine solénoïdale (30, 31) inscrite dans un même tube de cet espace annulaire cylindrique et contribuant à produire un gradient de champ X ou Y dans une direction x orthogonale à la première direction.

**3.** Machine selon l'une des revendications 1 et 2, **caractérisée en ce que** l'espace annulaire comporte une paroi interne (4) et/ou, sur une paroi externe (3), des bobines annulaires (53, 54) de production d'un gradient de champ magnétique orienté selon la direction z du champ principal et, dans l'épaisseur (10) comprise entre ces deux parois, des bobines solénoïdales produisant des gradients de champ X et/ou Y dans des directions x ou y perpendiculaires à la direction z de ce champ principal.

**4.** Machine selon la revendication 1, **caractérisée en ce qu'**elle comprend des moyens pour appliquer dans une bobine pour produire un gradient une composante d'un courant qui est proportionnelle à un courant nominal multiplié par un coefficient 1, 0,732 ou 0,268, en fonction d'un angle de repérage de la bobine sur le pourtour de l'espace annulaire et dans le cas où n vaut 6.

**5.** Machine selon l'une des revendications 1 à 4, **caractérisée en ce que** l'espace annulaire comporte plusieurs tubes contigus répartis sur le pourtour pour recevoir les bobines solénoïdales circulaires, le rayon a d'un tube étant donné par $a = r1(\sin\pi/N)/(1-\sin\pi/N) = r2(\sin\pi/N)/(1-\sin\pi/N)$, formule dans laquelle N représente le nombre de tubes et r1 et r2 les rayons intérieur et extérieur respectivement de l'espace annulaire.

**6.** Machine selon l'une des revendications 1 à 5, **caractérisée en ce que** l'espace annulaire comporte plusieurs tubes répartis sur le pourtour pour recevoir les bobines solénoïdales, six bobines (21-24, 30, 31) étant engagées dans un tube, les structures et positions de ces six bobines étant symétriques par rapport à un plan central (13) du tube perpendiculaire à l'axe (12) de ce tube.

**7.** Machine selon l'une des revendications 1 à 6, **caractérisée en ce que** chaque bobine solénoïdale circulaire est associée à des moyens d'alimentation électrique individualisée comprenant un amplificateur.

**8.** Machine selon l'une des revendications 1 à 7, **caractérisée en ce que** les bobines solénoïdales circulaires sont formées de spires, de préférence à profil rectangulaire, hélicoïdales allongées le long de manchons (60) circulaires conducteurs, plusieurs manchons d'une même bobine étant concentriques et engagés les uns dans les autres.

**9.** Machine selon la revendication 8, **caractérisée en ce qu'**elle comprend des moyens pour alimenter l'espace annulaire entre deux manchons par un fluide de refroidissement.

**10.** Machine selon l'une des revendications 1 à 9, **caractérisée en ce que** les dispositifs de production de gradient de champ comportent une bobine de gradient Z de compensation pour compenser des effets de courant de Foucault dus à un caractère pulsé d'impulsions de gradient de champ dans la direction z d'une génératrice de la machine.

**11.** Machine selon la revendication 1, **caractérisée en ce que** les dispositifs de production de gradient de champ comportent uniquement des bobines solénoïdales circulaires pour produire des gradients X et/ou Y dans lesdites directions radiales x et/ou y perpendiculaires à ladite direction z de la machine, les bobines de gradient pour produire des gradients dans des directions colinéaires avec ladite direction z de la machine étant réalisées sous la forme de bobines annulaires déployées à l'extérieur (53, 54) de l'espace annulaire.

## Patentansprüche

**1.** Kernspinresonanzmaschine vom zylindrischen kreisförmigen Typ (1-3), umfassend einen zylindrischen Ringraum (6), in dem kreisförmige Solenoidspulen (21-24, 30, 31) aufgenommen sind, deren Durchmesser (2a) innerhalb einer Dicke (10) des Ringraumes liegt und deren Achse zur Richtung z des Hauptfeldes parallel verläuft, wobei diese Spulen eine erste Anordnung von kreisförmigen Solenoidspulen umfassen, die geeignet sind, einen ersten Feldgradienten X in einer ersten radialen Richtung x der Maschine zu erzeugen, wobei diese Spulen der ersten Anordnung untereinander eine Ausführungssymmetrie in Bezug auf eine erste Ebene xOz, die zu der Maschine radial ist und die diese Richtung x enthält, aufweisen, sowie eine zweite Anordnung von kreisförmigen Solenoidspulen, die geeignet sind, einen zweiten Feldgradienten Y in einer zweiten radialen Richtung y der Maschine zu erzeugen, wobei die erste Richtung x zu der zweiten Richtung y senkrecht verläuft, wobei die zweite Anordnung zu der ersten Anordnung identisch ist und in der Maschine in einer Position vorliegt, die gegenüber einer Rotationsachse Oz der Maschine, welche zu der Richtung z des Hauptfeldes parallel ist, um 90° gedreht ist, wobei diese Spulen der zweiten Anordnung untereinander eine Ausführungssymmetrie in Bezug auf eine zu der ersten Ebene xOz senkrechte zweite radiale Ebene yOz aufweisen, wobei die kreisförmigen Solenoidspulen der ersten und der zweiten Anordnung von kreisförmigen Solenoidspulen entlang dem Umfang des Ringraumes in einer geraden Anzahl von 2n Anordnungen von identischen koaxialen Solenoidspulen, welche in Röhren eingesteckt und von der Rotationsachse Oz gleichbeabstandet sind, mit n ganze Zahl, derart verteilt sind, daß alle Spulen eine Symmetrie in Bezug auf die Ebenen xOz und yOz aufweisen, wobei die Maschine Verstärker umfaßt, um alle kreisförmigen Solenoidspulen der ersten und der zweiten Anordnung zu versorgen, **dadurch gekennzeichnet, daß** die gleichen kreisförmigen Solenoidspulen zur Erzeugung des Feldgradienten X und des Feldgradienten Y dienen und daß Mittel vorgesehen sind, um die gleichen kreisförmigen Solenoidspulen gleichzeitig durch Kombinationen von Strömen zu versorgen, um einen Feldgradienten X und einen Feldgradienten Y zu erzeugen, wobei der Strom in einer Spule zu dem Kosinus des Winkels der Röhre, welche die Spule am Umfang des Ringraumes enthält, proportional ist.

2. Maschine nach Anspruch 1, **dadurch gekennzeichnet, daß** eine kreisförmige Solenoidspule (21-24), deren Durchmesser in dem zylindrischen Ringraum enthalten ist und die zur Erzeugung eines Feldgradienten Z in einer zu der Hauptfeldrichtung parallelen ersten Richtung z beiträgt, zu einer weiteren Solenoidspule (30, 31), die in einer gleichen Röhre dieses zylindrischen Ringraumes enthalten ist und zur Erzeugung eines Feldgradienten X oder Y in einer zu der ersten Richtung orthogonalen Richtung x beiträgt, koaxial ist.

3. Maschine nach einem der Ansprüche 1 und 2, **dadurch gekennzeichnet, daß** der Ringraum eine Innenwand (4) und/oder, an einer Außenwand (3), ringförmige Spulen (53, 54) zur Erzeugung eines Magnetfeldgradienten, der in der Richtung z des Hauptfeldes ausgerichtet ist, sowie, in der Dicke (10) zwischen diesen beiden Wänden, Solenoidspulen umfaßt, die Feldgradienten X und/oder Y in Richtungen x oder y, welche zur Richtung z dieses Hauptfeldes senkrecht verlaufen, erzeugen.

4. Maschine nach Anspruch 1, **dadurch gekennzeichnet, daß** sie Mittel umfaßt, um in einer Spule zur Erzeugung eines Gradienten eine Komponente eines Stroms anzulegen, die proportional ist zu einem Nennstrom multipliziert mit einem Koeffizienten 1, 0,732 oder 0,268, in Abhängigkeit eines Markierungswinkels der Spule am Umfang des Ringraumes und in dem Fall, in dem n gleich 6 ist.

5. Maschine nach einem der Ansprüche 1 bis 4, **dadurch gekennzeichnet, daß** der Ringraum mehrere über den Umfang verteilte benachbarte Röhren umfaßt, um die kreisförmigen Solenoidspulen aufzunehmen, wobei der Radius a einer Röhre durch $a = (\sin\pi/N)/(1 - \sin\pi/N) = r2(\sin\pi/N)/(1 - \sin\pi/N)$ angegeben ist, Formel, worin N die Anzahl der Röhren sowie r1 und r2 den Innen- bzw. den Außenradius des Ringraums darstellt.

6. Maschine nach einem der Ansprüche 1 bis 5, **dadurch gekennzeichnet, daß** der Ringraum mehrere über den Umfang verteilte Röhren umfaßt, um die Solenoidspulen aufzunehmen, wobei sechs Spulen (21-24, 30, 31) in eine Röhre eingesteckt sind, wobei die Strukturen und Positionen dieser sechs Spulen in Bezug auf eine Mittelebene (13) der Röhre, die zu der Achse (12) dieser Röhre senkrecht verläuft, symmetrisch sind.

7. Maschine nach einem der Ansprüche 1 bis 6, **dadurch gekennzeichnet, daß** jede kreisförmige Solenoidspule Mitteln zur individualisierten Stromversorgung, die einen Verstärker umfassen, zugeordnet ist.

8. Maschine nach einem der Ansprüche 1 bis 7, **dadurch gekennzeichnet, daß** die kreisförmigen Solenoidspulen von länglichen schraubenförmigen Windungen, vorzugsweise mit rechteckigem Profil, entlang von leitenden kreisförmigen Manschetten (60) gebildet sind, wobei mehrere Manschetten einer gleichen Spule konzentrisch und ineinander gesteckt sind.

9. Maschine nach Anspruch 8, **dadurch gekennzeichnet, daß** sie Mittel umfaßt, um den Ringraum zwischen zwei Manschetten mit einem Kühlmittel zu beaufschlagen.

10. Maschine nach einem der Ansprüche 1 bis 9, **dadurch gekennzeichnet, daß** die Vorrichtungen zur Erzeugung eines Feldgradienten eine Z-Gradienten-Ausgleichsspule umfassen, um Wirbelstromeffekte, die durch einen gepulsten Charakter von Feldgradienten-Impulsen in der Richtung z einer Mantellinie der Maschine bedingt sind, zu kompensieren.

11. Maschine nach Anspruch 1, **dadurch gekennzeichnet, daß** die Vorrichtungen zur Erzeugung eines Feldgradienten lediglich kreisförmige Solenoidspulen umfassen, um Gradienten X und/oder Y in den zu der Richtung z der Maschine senkrechten radialen Richtungen x und/oder y zu erzeugen, wobei die Gradientenspulen zur Erzeugung von Gradienten in Richtungen, die zu der Richtung z der Maschine kollinear sind, in Form von entfalteten ringförmigen Spulen außerhalb (53, 54) des Ringraums ausgebildet sind.

## Claims

1. An NMR machine (1-3) of the circular cylindrical type comprising a cylindrical annular space (6) occupied by circular solenoidal coils (21-24, 30, 31) whose diameter (2a) is inscribed within a thickness (10) of the annular space and whose axis is parallel to the direction z of the main field, these coils comprising a first set of circular solenoidal coils adapted to generate a first field gradient X in a first radial direction x of the machine, these coils of the first set possessing among them a symmetry of construction relative to a first plane xOz that is radial to the machine and that contains this direction x, and a second set of circular solenoidal coils adapted to generate a second field gradient Y in a second radial direction y of the machine, the first direction x being perpendicular to the second direction y, the second set being identical to the first set and being presented in the machine in a position which is rotated by 90° with respect to an axis of revolution Oz of the machine which is parallel to the direction z of the main field, these coils of the second set possessing among them a symmetry of construction relative to a second radial plane yOz that is perpendicular to said first plane xOz, the circular solenoidal coils of said first and second sets of circular solenoidal coils being distributed around the perimeter of the annular space in an even number of 2n arrangements of identical coaxial solenoidal coils accommodated into tubes and being at the same distance from the axis of revolution Oz, n being an integer, in such a manner that the whole set of coils is symmetrical with respect to the planes xOz and yOz, the machine comprising amplifiers for simultaneously feeding these circular solenoidal coils of said first and second sets, **characterized in that** the same circular solenoidal coils are used for creating the field gradient X and the field gradient Y, and **in that** means are provided for simultaneously feeding said same cicular solenoidal coils with combinations of currents for creating a field gradient X and a field gradient Y, the current in a coil being proportional to the cosine of the angle of the tube which contains the coil around the perimeter of the annular space.

2. The machine as claimed in claim 1, **characterized in that** a circular solenoidal coil (21-24), the diameter of which is inscribed within the cylindrical annular space and which contributes to generate a field gradient Z in a first direction z which is parallel to the direction of the main field, is coaxial with another solenoidal coil (30, 31) inscribed within the same tube in this cylindrical annular space and contributing to generate a field gradient X or Y in a direction x or y which is perpendicular to the first direction.

3. The machine as claimed in one of claims 1 and 2, **characterized in that** the annular space includes, an internal wall (4) and/or on an external wall (3), annular coils (53, 54) for generating a magnetic field gradient oriented along the direction z of the main field, and, in the thickness (10) lying between these two walls, solenoidal coils generating field gradients X and/or Y in directions x or y perpendicular to the direction z of this main field.

4. The machine as claimed in claim 1, **characterized in that** it comprises means for applying in a coil for generating a gradient one component of a current which is proportional to a nominal current multiplied by a coefficient 1, 0.732 or 0.268, depending on the angle for locating the coil around the perimeter of the circular space, and in the case where n is equal to 6.

5. The machine as claimed in one of claims 1 to 4, **characterized in that** the annular space includes several contiguous tubes distributed around the perimeter in order to accommodate the circular solenoidal coils, the radius a of a tube being given by $a=r_1(\sin\pi/N)/(1-\sin\pi/N) = r_2(\sin\pi/N)/(1-\sin\pi/N)$, in which formula N represents the number of tubes and $r_1$ and $r_2$ are the inner radius and outer radius of the annular space, respectively.

6. The machine as claimed in one of claims 1 to 5, **characterized in that** the annular space includes several tubes distributed around the perimeter in order to accommodate the solenoid coils, six coils (21-24, 30, 31) being fitted into a tube, and the structures and positions of these six coils being symmetrical relative to a central plane (13) of the tube perpendicular to the axis (12) of this tube.

7. The machine as claimed in one of claims 1 to 6, **characterized in that** each circular solenoidal coil is associated with individual power supply comprising an amplifier.

8. The machine as claimed in one of claims 1 to 7, **characterized in that** the circular solenoidal coils are formed from elongate helicoidal turns, preferably of rectangular profile, along conducting circular sleeves (60), several sleeves of any one coil being concentric and nested one in another.

9. The machine as claimed in claim 8, **characterized in that** it comprises means for feeding a cooling fluid through an annular space between two sleeves.

**10.** The machine as claimed in one of claims 1 to 9, **characterized in that** the field gradient generating devices comprise a compensating coil of gradient Z for compensating for the effects of eddy currents due to the pulsed character of pulses for field gradients in the direction z of a generatrix of the machine.

**11.** The machine as claimed in claim 1, **characterized in that** the field gradient generating devices comprise only circular solenoidal coils for generating field gradients X and/or Y in said radial directions x and/or y perpendicular to said direction z of the machine, the gradient coils for generating gradients in directions collinear with said direction z of the machine being produced in the form of annular coils deployed on the outside (53, 54) of the annular space.

1
x
3
2
4
6
r1
r2
α2
α1
φ
0
θ
z
BO
5
8
P
y
I
7

Fig. 1

43
58
59
44
y
t
x
1
1
45
x
$\sqrt{3}/2$
54
55
46
1
47
6
0,4
56
1/2 1
11
12
48
0 1
10
0,2
57
10mm
53
49
550
y
-0,4
-0,2
0,2
0,4
r1
9
1000mm
a
r2
57
-0,2
50
$-\frac{1}{2}-1$
56
-0,4
51
52
$-\sqrt{3}/2-1$
-1
-1

Fig. 2

14
12
16
z
15
18
17
gradient Z simple
13
12
z
20
21
19
gradient Z homogène au 3ème ordre
26
25
12
z
24
22
21
23
gradient Z homogène au 5ème ordre
12
z
28
29
27
gradient X simple
12
z
31
32
30
gradient X homogène au 3ème ordre
37
36
12
z
35
34
33
gradient X homogène au 5ème ordre
42
39
41
40
38
12
z
24
31
22
21
30
23
gradient Z homogène au 5ème ordre
gradient X homogène au 3ème ordre

Fig. 3

69
70
68
61
66
60
63
62
64
67
65

Fig. 4

x
1
√3/2
√3/2
30°
1/2
1/2
0
0
y
3G
-1/2
-1/2
-√3/2
-√3/2
-1
x
+1
+1
0,732
15°
0,732
15°
0,268
0,268
y
-0,268
3,106G
-0,268
-0,732
-0,732
-1
-1

Fig. 5a

Fig. 5b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- EP 0221810 A
- WO A8903031 A
- US 5530355 A


### Littérature non-brevet citée dans la description


- **AN DA YEO.** *Quiet magnetic resonance imaging gradients,* Octobre 2000, 31